# EUROPEAN PATENT APPLICATION

(11) **EP 3 085 569 A1**
(43) Date of publication of application: **26.10.2016**
(21) Application number: 16163947.1
(22) Date of filing: 05.04.2016
(51) Int. Cl.: B60L 11/18, H05K 7/00, H02J 7/00

(54) **CONTROL BOX FOR ELECTRIC VEHICLE CHARGER**

(30) Priority: 22.04.2015 KR 20150056882
(71) Applicant: LSIS Co., Ltd., Gyeonggi-do 14119 (KR)
(72) Inventor: MOON, Ki-Young, 14118 Gyeonggi-do (KR)
(74) Representative: Zacco Sweden AB

(57) **Abstract**

The present invention relates to a control box (100) for an electric vehicle charger that provides enhanced manipulation convenience and an improved waterproof function.

According to an embodiment of the present invention, the control box (100) includes a case (101) having a circuit board (110) therein, the circuit board (110) comprising a light emitting unit (111) and a switch (113), a cover member (130) attached to an upper portion of the case (101) and configured to allow light emitted from the light emitting unit (111) to be transmitted therethrough, the cover member (130) including a press protrusion (131) to press the switch (113), and an exterior member (140) attached to an upper portion of the cover member (130).

## Description

### BACKGROUND

### 1. Technical Field

The present invention relates to a control box for an electric vehicle charger and, more particularly, to a control box for an electric vehicle charger having a button which can be pressed and a waterproof function, thereby enhancing manipulability and durability.

### 2. Description of the Related Art

Recently, technologies for electric vehicles powered by electricity which is green energy (hereinafter, referred to as an electric vehicle) have been rapidly developed.

As well known in the art, an electric vehicle includes a motor to generate torque, a battery to supply power to the motor, an inverter to control the rate of rotation of the motor, a charger to electrically charge the battery, and a low-voltage DC-DC converter for vehicles.

Methods of charging the electric vehicle are divided into rapid charge and slow charge.

According to the rapid charge, a high voltage current is converted into a direct current in a rapid charger to directly charge the battery of the electric vehicle. Thus, it may take a short time to charge the battery.

According to the slow charge, a converter provided in the vehicle converts an external alternating current into a direct current, thereby charging the battery of the vehicle. In this case, it takes a long time to charge the battery. However, with this method, the battery can be charged even in the household.

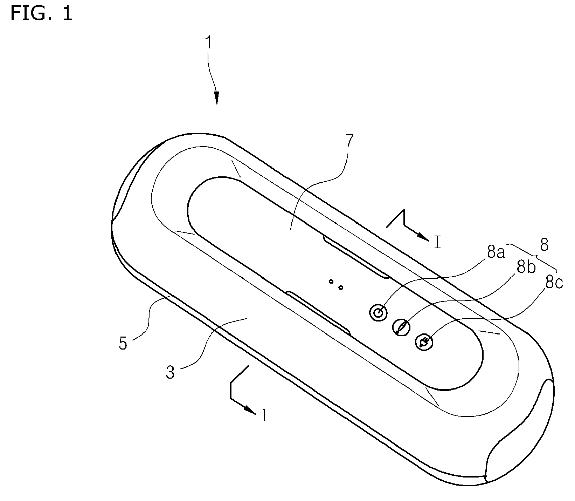

Fig. 1 is a diagram schematically illustrating a control box for a portable electric vehicle charger.

The illustrated portable electric vehicle charger is an appliance which may be used in a household. Referring to Fig. 1, the overall exterior of a control box 1 is defined by coupling between a lower case 5 and an upper case 3.

In this case, an exterior member 7 in the form of a film which is commonly called "Applique" is provided through the external surface of the upper case 3. The term "Applique", which refers to an object obtained by attaching small pieces of cloth, lace or leather to base cloth in a predetermined pattern, may be employed herein to refer to the attached exterior member having a size and shape corresponding to those of the exterior surface of the upper case 3.

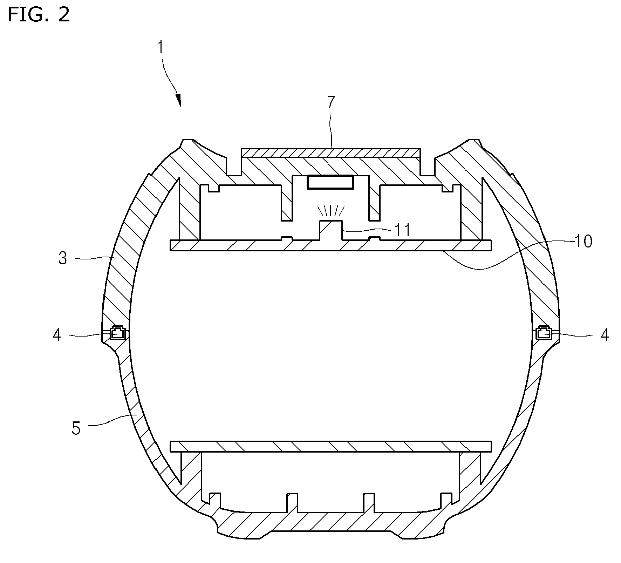

The exterior member 7 is provided with multiple signal portions 8 (8a, 8b, 8c) to deliver charging information to a user when a light emitting unit 11 (see Fig. 2) provided in the control box 1 is turned on.

That is, the user may recognize the charging information by confirming light output through one of the multiple signal portions 8 (8a, 8b, 8c).

Fig. 2 is an enlarged cross-sectional view, taken along line I-I. Referring to Fig. 2, the control box 1 is formed by coupling the lower case 5 and the upper case 3, and an O-ring 4 is provided through coupled portions of the lower case 5 and the upper case 3 to seal the internal space of the control box 1.

The sealed internal space of the control box 1 is provided with a circuit board 10 such as a printed circuit board (PCB).

The light emitting unit 11 may be turned on/off through the circuit board 10. The light emitting unit 11 is installed to face the exterior member 7 provided with multiple signal portions.

The rear surface of the exterior member 7 is provided with an adhesive means such as a double-sided tape. Thereby, once the exterior member 7 is adhered through the upper case 3, external moisture or water may be prevented from infiltrating into the control box through the adhered portions.

However, if the exterior member 7 is damaged or adhesiveness of the exterior member 7 is degraded, it is difficult to secure the waterproof function for the adhered portion of the exterior member 7.

In addition, the control box 1 for the conventional electric vehicle charger only serves to deliver charging information to the user through light emitted from the multiple signal portions 8 (8a, 8b, 8c) (see Fig. 1) and is not manipulatable.

### BRIEF SUMMARY

It is an aspect of the present invention to provide a control box for an electric vehicle charger which visually delivers the charging condition of an electric vehicle and has enhanced manipulability.

It is another aspect of the present invention to provide a control box for an electric vehicle charger which has enhanced durability according to enhancement of the waterproof function.

In accordance with one aspect of the present invention, a control box for an electric vehicle charger includes a case having a circuit board therein, the circuit board comprising a light emitting unit and a switch, a cover member attached to an upper portion of the case and configured to allow light emitted from the light emitting unit to be transmitted therethrough, the cover member comprising a press protrusion to press the switch, and an exterior member attached to an upper portion of the cover member.

The cover member may be formed of different materials, wherein the press protrusion is formed of rubber, and a remaining portion of the cover member other than the press protrusion may be formed of polycarbonate.

The upper portion of the case may be provided with a stepped groove, wherein the cover member may be attached to the upper portion of the case through the stepped groove.

The exterior member may include a button-shaped portion disposed to face the press protrusion to guide a manipulation position of the switch, and a signal portion disposed to face the light emitting unit to guide charging information through turning on of the light emitting unit.

According to embodiments of the present invention, a level of charge in an electric vehicle is displayed, and a switch enabling manipulation operations such as limiting the current is provided. Thereby, user convenience may be enhanced.

In addition, according embodiment of the present invention, a cover member formed of rubber is added between an exterior member and an upper case, thereby securing the waterproof function even if the exterior member is damaged or adhesiveness is lowered. Thereby, durability of products may be enhanced.

### BRIEF DESCRIPTION OF THE DRAWINGS

Fig. 1 is a perspective view schematically illustrating a control box for an electric vehicle charger according to the conventional art.
Fig. 2 is a cross-sectional view schematically illustrating a control box for the electric vehicle charger according to the conventional art.
Fig. 3 is a view schematically illustrating a control box for an electric vehicle charger according to an embodiment of the present invention.
Fig. 4 is an exploded view illustrating constituents of a control box for an electric vehicle charger according to an embodiment of the present invention.
Fig. 5 is a cross-sectional view schematically illustrating a control box for an electric vehicle charger according to an embodiment of the present invention.
Fig. 6 is a cross-sectional view stereoscopically illustrating a control box for an electric vehicle charger according to an embodiment of the present invention.

### DETAILED DESCRIPTION

Advantages and features of the present invention and methods to achieve them will become apparent from the descriptions of exemplary embodiments herein below with reference to the accompanying drawings. However, the present invention is not limited to exemplary embodiments disclosed herein but may be implemented in various different forms. The exemplary embodiments are provided for making disclosure of the present invention thorough and for fully conveying the scope of the present invention to those skilled in the art. It is to be noted that the scope of the present invention is defined only by the claims. Like reference numerals will be used to denote like elements throughout the specification.

Hereinafter, a detailed description will be given of a control box for an electric vehicle charger according to a preferred embodiment of the present invention with reference to the accompanying drawings.

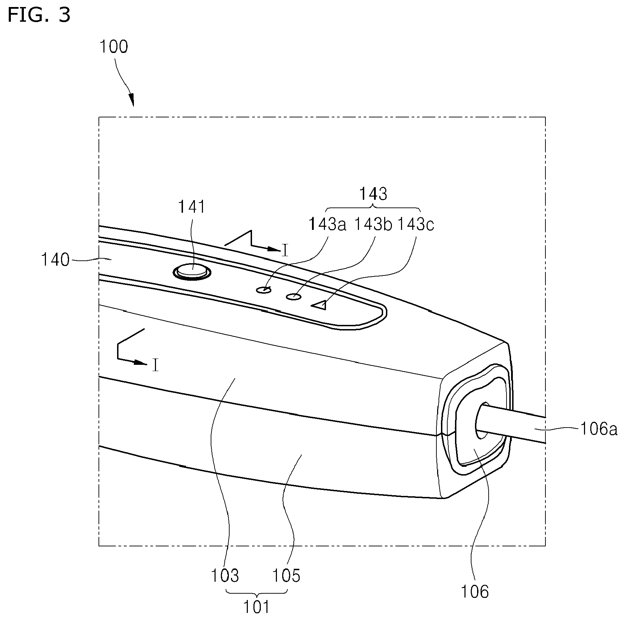

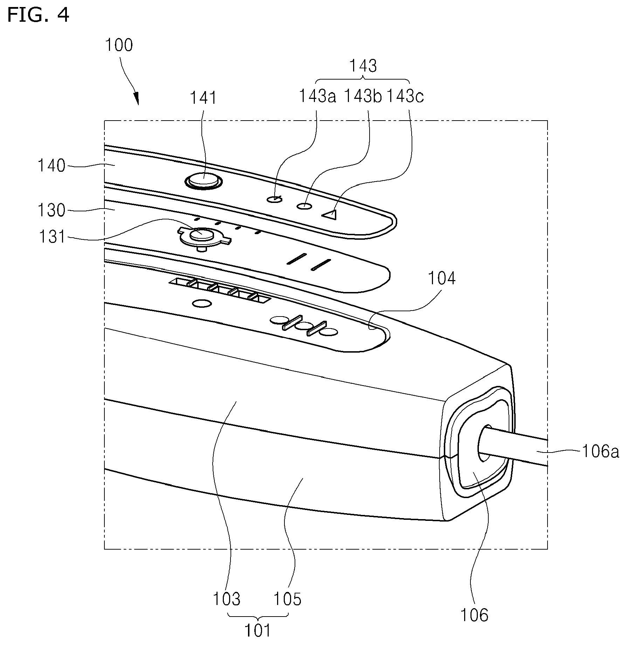

Fig. 3 is a view schematically illustrating a control box for an electric vehicle charger according to an embodiment of the present invention, and Fig. 4 is an exploded view illustrating constituents of the control box for an electric vehicle charger according to an embodiment of the present invention.

Referring to Figs. 3 and 4, a control box 100 for an electric vehicle charger (hereinafter, simply referred to as a control box) includes a case 101, a cover member 130 (see Fig. 4), and an exterior member 140.

The case 101 is a member defining the overall exterior of the control box 100.

The case 101 includes an upper case 103 and a lower case 105. The case 101 is not limited to the illustrated shape. The case 101 may have various shapes.

Although not as shown in the figures, an O-ring may be provided to coupled portions of the upper case 103 and a case 105 which are coupled to each other.

A cable 106a is retrievable through one side of the case 101. A bushing 106 may be coupled between the cable 106a and one side of the case 101. The bushing 106 refers to an insulator fitted into a part of the side portion of the case 101 through which the cable 106a extends outward in order to secure insulation.

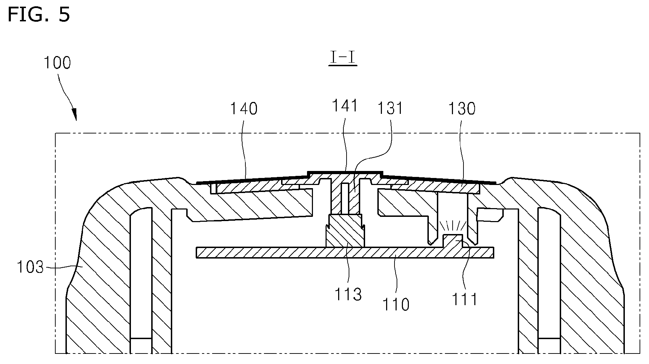

The case 101 has an internal space isolated from the outside by coupling between the upper case 103 and the lower case 105. A circuit board 110 (e.g., PCB) (see Fig. 5) having various electronic components mounted thereon may be installed in the internal space.

Fig. 5 is a cross-sectional view schematically illustrating a control box for an electric vehicle charger according to an embodiment of the present invention. Referring to Fig. 5, the circuit board 110 may be positioned close to the case, particularly, the upper case 103.

The circuit board 110 may include a switch 113, specifically, a tact switch 113 configured to receive a predetermined signal according to a pressing operation and a light emitting unit 111 (e.g., LED) configured to be turned on according to a charging condition. The light emitting unit 111 may include one or more light emitting units, and the number and colors thereof are not limited.

Referring Figs. 3 and 4, the cover member 130 refers to a member attached to the case 101, particularly, an upper portion of the upper case 103.

The cover member 130 and the exterior member 140, which will be described later, are attached to the upper portion of the upper case to prevent introduction of water (or moisture) into the internal space of the case 101.

That is, according to this embodiment, the waterproof function may be secured by the cover member 130 even if the exterior member 140 is damaged or separated due to deteriorated adhesiveness. Thereby, the waterproof function may be enhanced.

In addition, the cover member 130 may have a press protrusion 131 which is arranged at a position corresponding to the switch 113 (see Fig. 5) to apply pressure to the switch 113 (see Fig. 5) provided to the circuit board 110 (see Fig. 5) to operate the switch 113.

The cross-sectional shape of the press protrusion 131 is shown in Fig. 5.

As shown in Fig. 5, the lower end of the press protrusion 131 may extend to a position close to the switch 113 to press and operate the switch 113 installed on the circuit board 110.

In addition, the cover member 130 is preferably formed of a material allowing light emitted from the light emitting unit 111 (see Fig. 5) to be transmitted therethrough.

For example, the cover member 130 may be formed of polycarbonate which is generally transparent.

In addition, the press protrusion 131 may be formed of a material such as rubber which is elastically deformable to ensure that the switch 113 is pressed. However, embodiments of the present invention are limited to.

For example, when the cover member 130 is fabricated through injection molding using a polycarbonate material, the respective parts of the cover member 130 may be formed of different materials by inserting rubber into a portion where the press protrusion 131 is performed.

Referring to Fig. 4, a stepped groove 104 having a predetermined depth is formed at the upper portion of the upper case 103 to which the cover member 130 is attached. Herein, the predetermined depth refers to a dimension corresponding to the thickness of the cover member 130.

The cover member 130 may be attached to the upper case 103 through the stepped groove 104.

It can be seen from Fig. 5 that the depth of the stepped groove corresponds to the thickness of the cover member 130.

Although not shown in the figure, the rear surface of the cover member 130 may be provided with an adhesive means such as a double-sided tape. Using the adhesive means, the cover member 130 may be securely attached to the upper case 103 through the stepped groove 104.

If an adhesive means such as a double-sided tape is provided to the cover member 130, the stepped groove 104 may be formed to have a dimension corresponding to the sum of the thickness of the cover member 130 and the thickness of the adhesive means.

Referring to Figs. 3 and 4, the exterior member 140 is a film-type member attached to the cover member 130 through the upper surface of the cover member 130 and is referred to as Applique.

The exterior member 140 may be provided with a button-shaped upper portion 141 and multiple signal portions 143 (143a, 143b, 143c) having symbol shapes indicating charging conditions.

The button-shaped upper portion 141 may be disposed to face the press protrusion 131 (see Fig. 5).

Thereby, the user may check the manipulation position of the switch 113 (see Fig. 5) installed in the case 101 with the exterior member 140 attached, and press the button-shaped upper portion 141 to operate the switch 113 (see Fig. 3).

When the switch 113 (see Fig. 3) is pressed, a predetermined operation such as limiting the output current may be performed.

In addition, the multiple signal portions 143 (143a, 143b, 143c) may visually display the charging condition or charging information. For example, light emitted from light emitting unit 111 (see Fig. 5) may be transmitted through the cover member 130 and then emitted through one of the multiple signal portions 143 (143a, 143b, 143c) provided to the exterior member 140.

For example, one signal portion 143a of the multiple signal portions 143 may function to announce whether charging is being normally performed.

In addition, another signal portion 143b may function to verify power. The other signal portion 143c may function to signal the condition of connection with the battery of the electric vehicle. However, embodiments of the present invention are not limited thereto.

That is, the multiple signal portions 143 (143a, 143b, 143c) may not only allow the user to check the normal charging condition, the power condition, and the condition of connection with the battery of the electric vehicle, but also visually deliver various kinds of status information to the user.

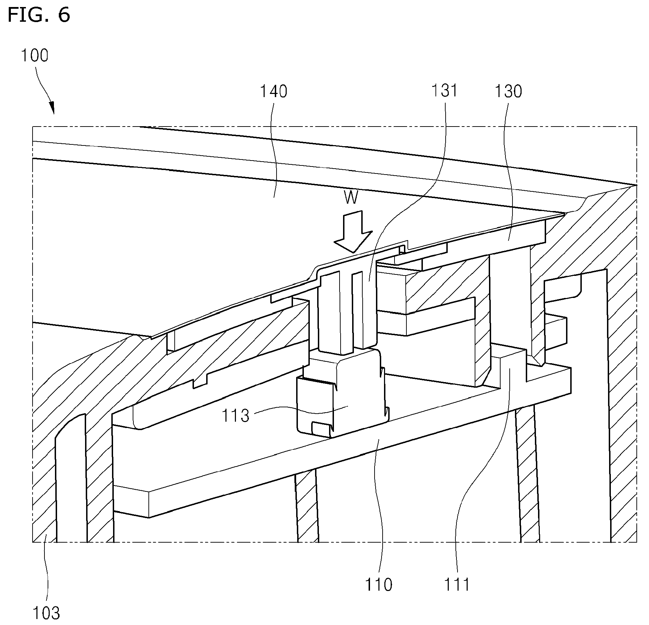

Fig. 6 is a cross-sectional view stereoscopically illustrating a control box for an electric vehicle charger according to an embodiment of the present invention.

Fig. 6 illustrates operating the switch 113 through the control box 100.

The user may press the exterior member 140, more specifically, the button-shaped portion 141 (see Fig. 5) in a direction denoted by W.

Thereby, the press protrusion 131 of the cover member 130 moves downward in the direction denoted by W along with the exterior member 140.

Subsequently, the switch 113 facing the lower end of the press protrusion 131 is pressed, and a predetermined operation may be performed.

As a dual waterproof structure is formed by the exterior member 140 and the cover member 130 and the switch 113 configured to be pressed for an operation is used, manipulability may be enhanced.

According to configuration and operation of the present invention as described above, the charging condition of the electric vehicle is displayed through the exterior, a tact switch for manipulation such as limiting the output current is provided, user convenience may be enhanced.

Further, as a cover member formed of rubber is arranged between an exterior member commonly called Applique and an upper case, the waterproof function may be secured even if the exterior member is damaging the or adhesiveness is degraded. Thereby, durability of the products may be enhanced.

Embodiments of a control box for an electric vehicle charger have been described above. It is apparent to those skilled in the art that various modifications can be made to the present invention without departing from the scope of the present invention.

The embodiments described above should be construed in all aspects as illustrative and not restrictive. The scope of protection sought by the present invention should be determined by the appended claims and their equivalents, and all changes coming within the meaning and equivalency range of the appended claims are intended to be embraced therein.

## Claims

1. A control box (100) for an electric vehicle charger, the control box (100) comprising:
a case (101) having a circuit board (110) therein, the circuit board (110) comprising a light emitting unit (111) and a switch (113);
a cover member (130) attached to an upper portion of the case (101) and configured to allow light emitted from the light emitting unit (111) to be transmitted therethrough, the cover member (130) comprising a press protrusion (131) to press the switch (113); and
an exterior member (140) attached to an upper portion of the cover member (130).

2. The control box (100) according to claim 1, wherein the cover member (130) is formed of different materials,
wherein the press protrusion (131) is formed of rubber, and a remaining portion of the cover member other than the press protrusion (131) is formed of polycarbonate.

3. The control box (100) according to claim 1, wherein the upper portion of the case(101) is provided with a stepped groove (104),
wherein the cover member (130) is attached to the upper portion of the case (101) through the stepped groove (104).

4. The control box (100) according to claim 1, wherein the exterior member (140) comprises:
a button-shaped portion (141) disposed to face the press protrusion (131) to guide a manipulation position of the switch (113); and
a signal portion (143) disposed to face the light emitting unit (111) to guide charging information through turning on of the light emitting unit.
